# EUROPÄISCHE PATENTSCHRIFT

(11) **EP 1 520 331 B1**
(45) Veröffentlichungstag und Bekanntmachung des Hinweises auf die Patenterteilung: **28.07.2010**
(21) Anmeldenummer: 03763653.7
(22) Anmeldetag: 25.06.2003
(51) Int. Cl.: H02H 9/04, H02M 1/00

(54) **VERFAHREN UND SCHALTUNGSANORDNUNG ZUM BEGRENZEN EINER ÜBERSPANNUNG**
METHOD AND CIRCUIT FOR LIMITING AN OVERVOLTAGE
PROCEDE ET ENSEMBLE CIRCUIT POUR LIMITER UNE SURTENSION

(30) Priorität: 10.07.2002 DE 10231198
(43) Veröffentlichungstag der Anmeldung: 06.04.2005
(73) Patentinhaber: Infineon Technologies AG, 85579 Neubiberg (DE)
(72) Erfinder: MÜNZER, Mark, 59494 Soest (DE); BAYERER, Reinhold, 59581 Warstein (DE); KANSCHAT, Peter, 59505 Bad Sassendorf (DE)
(74) Vertreter: Schmuckermaier, Bernhard
(86) Internationale Anmeldenummer: PCT/EP2003/006700
(87) Internationale Veröffentlichungsnummer: WO 2004/008601

(56) Entgegenhaltungen:
- DE-A- 4 038 199
- US-A- 4 679 112

## Beschreibung

Die Erfindung betrifft ein Verfahren und eine Schaltungsanordnung zum Begrenzen einer Überspannung, die durch Schalten einer induktiven Last, wie zum Beispiel einem Elektromotor, auf einen Lasttreiber zurückwirkt.

Wenn induktive Lasten geschaltet werden, so entstehen beim Ausschalten hohe induktive Gegenspannungen, die den Lasttreiber zerstören können. Um die Überspannungen zu vermindern, ist es üblich so genannte Freilaufdioden parallel zu dem Lasttreiber zu schalten, die Überspannungen oder Stromspitzen von dem Lasttreiber ableiten. Aus der DE 40 38 199 A1 ist es bekannt, bei einer Anordnung von vier Lasttreibern in vollbrückenschaltung anstelle von Freilaufdioden die Lasttreiber selbst zum Abkommutieren zu verwenden. Dabei werden die Lasttreiber im Abkommutierungsfall so angesteuert, dass anders als im Normalbetrieb, wo die Lasttreiber entlang einer der beiden Brückendiagonalen durchgeschaltet sind, entweder die beiden oberen oder die beiden unteren Lasttreiber der vollbrückenschaltung durchgeschaltet werden.

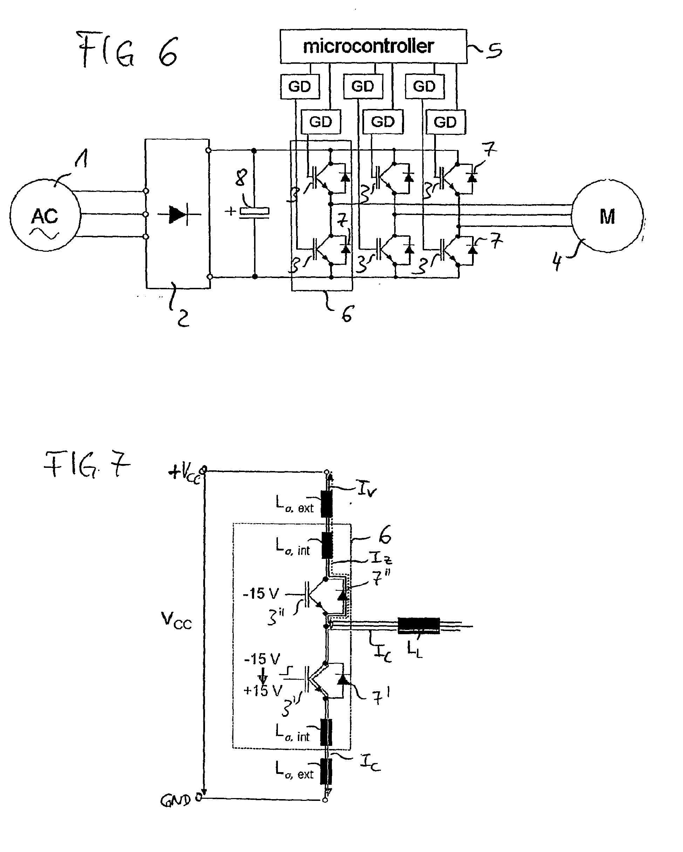

Eine Anwendung, bei der eine induktive Last gesteuert wird, ist zum Beispiel eine Umrichterschaltung, mit der ein Elektromotor betrieben wird. In Figur 6 ist eine bekannte Umrichterschaltung schematisch dargestellt. Eine z. B. dreiphasige Wechselspannung einer Wechselspannungsquelle 1 wird zunächst durch eine Gleichrichterstufe 2 gleichgerichtet, mit Hilfe von Lasttreibern 3 in eine Wechselspannung variabler Ausgangsfrequenz umgewandelt und einer Last 4 (hier ein dreiphasiger Elektromotor M) zugeführt. Die Signale zur Generation der Ausgangsspannung liefert ein Mikrocontroller 5. Diese werden mit Hilfe von Gate-Treibern GD in geeignete Impulse für die Ansteuerung der Lasttreiber 3 umgewandelt. Ein Grundelement einer solchen Anordnung ist eine Halbbrücke 6 (in Figur 6 eingerahmt dargestellt).

In einem solchen Umrichter für elektrische Antriebe besitzt die Last 4 in Form eines elektrischen Motors M induktive Anteile. Mit dem Umrichter werden in den drei Phasen des Motors M annähernd sinusförmige Ströme durch pulweitenmoduliertes Schalten von Lasttreibern 3 erzeugt. Zum Schutz vor induzierten Überspannungen weist jeder Lasttreiber 3 jeweils eine parallel zu ihm angeordnete Freilaufdiode 7 auf. Aufgrund der induktiven Anteile in der Last 4 kommutiert dabei der Strom zwischen dem Lasttreiber 3 und der entsprechenden Freilaufdiode 7 innerhalb einer Halbbrücke 6 hin und her (vgl. Figuren 6 und 7) .

Eine solche Halbbrücke 6 ist in Figur 7 separat dargestellt und weist jeweils zwei in Serie geschaltete Lasttreiber 3 auf, die zwischen einem Versorgungspotenzial +V_{CC} und einem Bezugspotenzial 0 V angeordnet sind. Jedem Lasttreiber ist jeweils eine Freilaufdiode 7 parallel geschaltet. Die Last 4 ist an den gemeinsamen Anschluss der beiden Lasttreiber 3 angeschlossen. So entsteht eine Brückenschaltung, die es erlaubt, die Last 4 mit einer Wechselspannung anzusteuern.

Die Versorgungsspannung V_{CC} wird in einem Zwischenkreiskondensator 8 zwischengespeichert, der die Versorgungsspannung V_{CC} für alle Halbbrücken 6 liefert. Ein Zwischenkreis wird durch den Zwischenkreiskondensator 8 und eine Halbbrücke 6 gebildet.

In jeder Halbbrücke 6 wirken bauteilinterne Streuinduktivitäten L_{σ,int} und durch den Aufbau bedingte externe Streuinduktivitäten L_{σ,ext} zusätzlich zu der Induktivität der Last 4. Die beiden Lasttreiber 3 werden so angesteuert, dass nur jeweils einer der beiden Lasttreiber leitet, während der andere gesperrt ist.

In Figur 7 ist zusätzlich der prinzipielle Stromverlauf in einer Halbbrücke 6 bei Kommutierung eines Stromes aus der induktiven Last L_{L} von der oberen Freilaufdiode 7 in den unteren, einschaltenden Lasttreiber 3 dargestellt (die Lasttreiber 3 schalten wechselweise; während der eine eingeschaltet ist, ist der andere ausgeschaltet). Vor dem Einschaltvorgang fließt der durch die obere Freilaufdiode 7 freilaufende Strom I_{V} durch die Last L_{L}, die obere Freilaufdiode 7 und die beiden inhärent vorhandenen Streuinduktivitäten L_{σ,int} und L_{σ,ext}-Nach Abschluss des Kommutierungsvorganges, d.h. bei eingeschaltetem unteren Lasttreiber 3 (üblicherweise werden als Lasttreiber 3 Schalter in Halbleiterauaführung verwendet und daher auch als Leistungshalbleiter oder Halbleiterleistungsschalter bezeichnet) fließt der Strom durch die Last L_{L} und durch den unteren Lasttreiber 3 sowie die unteren Streuinduktivitäten L_{σ,int} und L_{σ,ext}. Gestrichelt eingezeichnet ist der Strombeitrag I_{z} durch den Übergang der Freilaufdiode 7 vom leitenden in den sperrenden Zustand während des Schaltvorgangs.

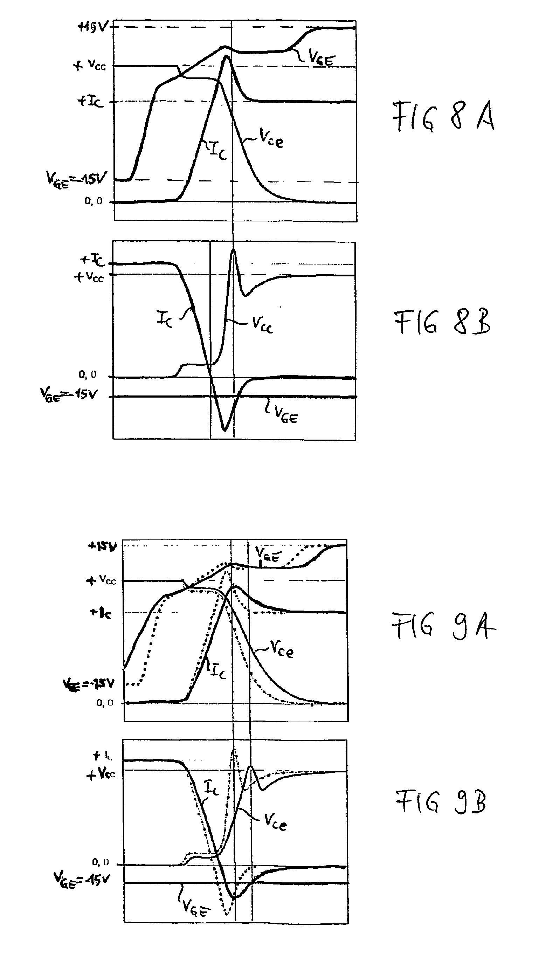

Dieser Anteil verursacht die in den Figuren 8A bis 9B gezeigten Rückstromspitzen. Die bauteilinternen und aufbaubedingten externen Streuinduktivitäten L_{σ,int} bzw. L_{σ,ext} könnten während des Abklingen der Rückstromspitze eine Überspannung größer als die Zwischenkreisspannung oder Versogungsspannung V_{CC} an der Freilaufdiode 7 induzieren, die u.U. die für den Lasttreiber 3 oder die Freilaufdioden 7 maximal zulässige Spannung übersteigt (Freilaufdiode 7 kann zerstört werden) .

Bei der Übernahme des Stromes von der Freilaufdiode 7 in den Lasttreiber 3 wird die Steilheit des Stromanstiegs in dem Lasttreiber 3 durch die Ansteuerung des Lasttreibers 3 bestimmt. Zusätlich zu dem Strom aus der Last L_{L} entsteht eine so genannte Rückstromspitze, die durch die Speicherladung der Freilaufdiode 7 bedingt ist. Die additive Rückstromspitze wird aus dem Zwischenkreißkondensator 8 gespeist und fließt über die Streuinduktivitäten L_{σ,int} bzw. L_{σ,est} im Zwischenkreis. Je nach Optimierung der Freilaufdioden 7 fällt diese Rückstromispitze mehr oder weniger schnell ab. Höhe und Abklinggeschwindigkeit sind durch die Steilheit di/dt des Stromanstieges im Lasttreiber 3 beeinflussbar.

Je nach Größe der Streuinduktivitäten L_{σ,int} und L_{σ,ext} im Zwischenkreis und Stromsteilheit di/dt entsteht beim Anstieg des Stromes im Lasttreiber 3 ein Spannungseinbruch an der Halbbrücke 6 und dem Lasttreiber 3, der durch das Gesetz u(L_{σ}) = L_{σ}*di/dt bestimmt ist. Beim Abklingen der Rückstromspitze entsteht an diesen Streuinduktivitäten L_{σ,int} und L_{σ,ext} eine umgekehrte Spannung, die an der Freilaufdiode 7 eine Spannungsspitze erzeugt. Bei sehr schnell abreißenden Freilaufdioden 7 können durch hohe Streuinduktivitäten L_{σ,int} und L_{σ,ext} Überspannungsspitzen bis zur Zerstörungsgrenze entstehen.

In den Figuren 8A und 8B ist die Spannung am Bauteil V_{ce} beim Schaltvorgang, der geschaltete Laststrom I_{C} durch den Lasttreiber 3 und die Gate-Spannung V_{GE} am schaltenden Lasttreiber 3' (Figur 8A) und an der Freilaufdiode 7 (mit dem parallel geschalteten, sperrenden Lasttreiber 3"; Figur 8B) schematisch dargestellt.

Beim Schalten steigt die Gate-Spannung V_{GE} am schaltenden Lasttreiber 3' von -15 V auf +15 V, die Spannung V_{ce} am Lasttreiber 3 fällt von +V_{CC} (Plus-Potenzial der Versorgungsspannung oder Zwischenkreisspannung V_{CC}) auf annähernd 0 V. Der Strom durch den Lasttreiber (Laststrom I_{C}) steigt schnell an und nimmt nach einer kurzen Stromspitze seinen Nennwert I_{C} ein.

An der dem sperrenden Lasttreiber 3" parallel geschalteten Freilaufdiode 7" sinkt der Freilaufstrom vom Nennwert I_{C} auf Null (mit einem kurzen Überschwinger oder negativen Stromspitze; auch als Rückstromspitze bezeichnet) ab. Die dortige Gate-Spannung V_{GE} des gesperrten Lasttreibers 3" bleibt auf -15 V, während die Spannung V_{ce} am Lasttreiber von 0 V auf +V_{CC} ansteigt (ebenfalls mit einem kurzen, starken Überschwinger; auch als Überspannung bezeichnet).

Derartige Kommutierungsvorgänge (Stromumkehrung oder Umschaltung) finden auch in anderen Anwendungen mit induktiven Lasten und vergleichbaren Schaltvorgängen (zum Beispiel in Schaltnetzteilen) statt.

Zum Schutz der Freilaufdioden 7 vor solchen Überspannungen wurde bisher (zumindest firmenintern bekannt) der den Kommutierungsvorgang kontrollierende Lasttreiber 3 langsamer geschaltet, wodurch die Rückstromspitze sinkt und die Freilaufdiode 7 weniger steil abreißt (vgl. Figuren 9A und 9B).

In den Figuren 9A und 9B ist die Beeinflussung von Überspannung und Rückstromspitze durch langsameres Schalten des Lasttreibers mittels Verwendung eines größeren Gate-Wideretandes R_{G} dargestellt (Figur 9A zeigt die Verhältnisse am schaltenden Lasttreiber 3' und Figur 9B die Verhältnisse an der dem sperrenden Lasttreiber 3" parallel geschalteten Freilaufdiode 7"). Zum Vergleich sind jeweils die in den Figuren 8A bzw. 8B gezeigten Strom-/Spannungsverläufe gepunktet dargestellt. Insbesondere die Verluste im schaltenden Lasttreiber werden hierdurch, wie anhand der Strom-/spannungsverläufe in der Figur 8A zu sehen ist, deutlich erhöht.

Es ist - zumindest firmenintern - bekannt, die wirksame Streuinduktivität L_{σ} durch eine so genannte Snubberbeschaltung zu reduzieren. Wird die Stromsteilheit im Lasttreiber 3 durch langsamere Ansteuerung reduziert, führt dies zu erhöhtten, nicht akzeptablen Schaltverlusten im Lasttreiber 3. Eine Snubberbeschaltung erzeugt erhöhte Kosten und außerdem zusätzliche Verluste in der Snubberschaltung.

Es ist Aufgabe der Erfindung, ein Verfahren und eine Schaltungsanordnung zum Begrenzen einer Überspannung zu schaffen, durch die zusätzliche Verluste reduziert werden. Insbesondere sollen starke Überspannungen und Rückstromspitzen reduziert werden.

Diese Aufgabe wird durch ein Verfahren zum Begrenzen einer Überspannung mit den Merkmalen von Patentanspruch 1 und durch eine Schaltungsanordnung mit den Merkmalen von Patentanspruch 7 gelöst.

Dabei wird ein parallel zu einer Freilaufdiode liegender (Halbleiter-) Leistungsschalter (im Folgenden als Lasttreiber bezeichnet) als Begrenzer für die an der Freilaufdiode anstehende (Über-) Spannung während der Kommmutierung ausgenutzt. Die Begrenzung der Überspannung durch einen parallel dazu liegenden Lasttreiber wird dadurch erreicht, dass dieser Lasttreiber während des Abklingens einer Rückstromspitze kurzzeitig, gerade so weit eingeschaltet wird, dass ein additiver abfallender Strom im Halbleiterschalter-Freilaufdioden-Paar entsteht. Der additive, abfallende Strom reduziert somit die Stromsteilheit in schaltungsaufbaubedingten Streuinduktivitäten und reduziert die induzierten Spannungen. Das kurzzeitige Einschalten ist zeitlich auf das Auftreten der Rückstromspitze abgestimmt.

Vorteilhafte Weiterbildungen der Erfindung sind in den Unteransprüchen wiedergegeben.

So können als Halbleiterschalter so genannte IGBTs verwendet werden, bei denen der Steueranschluss und der Ausgangsanschluss des gesperrten Halbleiterschalters hochohmig miteinander verbunden werden, wodurch bei Auftreten einer Stromspitze ein kurzzeitiges Einschalten des Halbleiterschalters erreicht wird. Dies stellt eine sehr einfache Möglichkeit dar, der Spannungsspitze in bestimmtem Maße entgegenzuwirken.

Vorteilhaft ist es auch, den Steueranschluss des gesperrten Halbleiterschalters mit einem etwa rechteckförmigen Spannungsimpuls vorbestimmter Dauer und einer Amplitude kleiner als ein vorgegebener Schwellwert während des Auftretens einer Stromspitze oder zumindest während des Abklingens der Stromspitze zu beaufschlagen.

Noch vorteilhafter ist es, statt eines einfachen Rechteckimpulses einen stufenförmigen Spannungsimpuls zu verwenden, wobei die größte Amplitude kurzzeitig zumindest während des Abklingens der Rückstromspitze ansteht, um dieser Rückstromspitze entgegen zu wirken.

Die Spannung am Ansgangsanschluss des anderen, gesperrten Halbleiterschalters kann zusätzlich (oder auch allein) über einen Rückkoppelzweig auf seinen Steueranschluss zurückgekoppelt werden. Dadurch wird der gesperrte Halbleiterschalter während des Anstehens der Stromspitze oder induktiven Überspannung kurzzeitig eingeschaltet. Dies reduziert die Stromsteilheit im Abfall der Stromspitze und somit die Überspannung.

Dieser Effekt kann noch gesteigert werden, falls - zusätzlich zu der Rückkopplung - der Steueranschluss des Halbleiterschalters mit einem Spannungsimpuls während des Anstehens oder Abklingens der Stromspitze beaufschlagt wird, wodurch der eigentlich gesperrte Halbleiterschalter teilweise eingeschaltet wird.

Der Rückkoppelzweig weist vorteilhafterweise zumindest ein derartiges Bauelement auf, durch das der Rückkoppelzweig nur dann aktiviert wird, wenn die Spannung einen Schwellwert überschreitet. So können dafür zwei antiseriell geschaltete Zenerdioden verwendet werden. Dadurch wird erreicht, dass erst bei Überschreiten einer vorgegebenen Spannung ein Ansteuern und damit ein teilweises Einschalten des an sich gesperrten Halbleiterschalters erreicht wird, und dies zeitlich abgestimmt auf das Auftreten der Überspannung. Alternativ oder ergänzend kann der Spannungsanstieg an der Freilaufeinrichtung z.B. mit Hilfe eines Kondensators auf den Steueranschluss des Lasttreibers rückgekoppelt werden. Hierdurch wird der Kommiterungsvorgang derart beeinflusst, dass Höhe und Steilheit der Rückstromspitze abnehmen. Somit ist mit einfachen kostengünstigen Mitteln eine effektive Reduzierung einer induktiven Überspannung und das Reduzieren von schädlichen Stromspitzen mit großer Stromsteilheit möglich, Zudem wird die der Überspannung oder der Rückstromspitze entgegenwirkende Ansteuerung des Halbleiterschalters zeitlich auf die Anwesenheit der Rückstromspitze abgestellt. Die Schwelle, ab der die Rückkopplung aktiviert werden soll, kann auch einfach durch entsprechende Dimensionierung der Bauelemente im Rückkopplungszweig eingestellt werden.

Ausführungsbeispiele der Erfindung werden im Folgenden anhand der schematischen Zeichnungen näher erläutert. Es zeigen:
- Figuren 1A und 1B: Strom-/Spannungsverläufe an einem einschal- tenden Halbleiterschalter bzw. an einer einem sper- renden Halbleiterschalter parallel geschalteten Freilaufdiode,
- Figur 2: ein erstes Ausführungsbeispiel einer erfindungsgemä- ßen Schaltungsanordnung mit einem Rückkoppelzweig mit Zenerdioden,
- Figur 3A: ein weiteres Ausführungsbeispiel einer erfindungsge- mäßen Schaltungsanordnung mit einem Rückkoppelzweig mit einem gesonderten Kondensator,
- Figur 3B: ein weiteres Ausführungsbeispiel einer erfindungs- gemäßen Schaltungsanordnung mit einem Rückkoppel- zweig für ein Signal proportional zur Stromsteilheit in der Diode,
- Figuren 4 und 5: Strom-/Spannungsverläufe an einem einschal- tenden Halbleiterschalter entsprechend zwei Ausfüh- rungsbeispielen eines erfindungsgemäßen Verfahrens,
- Figur 6: eine bekannte Umrichterschaltung zum Steuern eines dreiphasigen Elektromotors,
- Figur 7: eine Halbbrücke der bekannten Umrichterschaltung ge- mäß Figur 5 mit den darin vorkommenden elektrischen Strömen,
- Figuren 8A und 8B: Strom-/Spannungsverläufe an einem einschal- tenden Halbleiterschalter der Halbbrücke nach Figur 6 und
- Figuren 9A und 9B: Strom-/Spannungsverläufe an einem einschal- tenden Halbleiterschalter der Halbbrücke nach Figur 6 bei Verwendung eines größeren Gate-Widerstandes.

Bei den Figuren und den Ausführungsbeispielen haben funktionell gleichartige Teile identische Bezugszeichen erhalten.

Zum Steuern oder Schalten von induktiven Lasten L_{L}, wie zum Beispiel einem Elektromotor (vgl. Figur 6), werden als Treiber häufig Leistungshalbleiterbauelemente (als Leistungsschalter, als Lasttreiber 3 oder auch als Halbleiterschalter bezeichnet) verwendet. Die Lasttreiber 3 selber werden üblicherweise von einer Steuereinheit mit einem Mikrocontroller 5 gesteuert. Da beim Schalten von induktiven Lasten L_{L}, insbesondere beim Abschalten der Lasten L_{L}, unerwünschte, hohe Spannungen induziert werden, sind parallel zu jedem Lasttreiber 3 jeweils eine Freilaufdiode 7 geschaltet, die eine induzierte Überspannung reduzieren soll.

Üblich ist es, eine Halbbrücke 6 zum Steuern einer induktiven Last L_{L} zu verwenden, wobei zwei Lasttreiber 3 mit jeweils parallel geschalteten Freilaufdioden 7 hintereinander geschaltet sind und wechselweise schalten (der eingeschaltete Lasttreiber wird mit 3' und der gesperrte Lasttreiber mit 3" bezeichnet). Zwischen den beiden Lasttreibern 3 ist der Ausgangsanschluss für eine induktive Last L_{L} angeordnet.

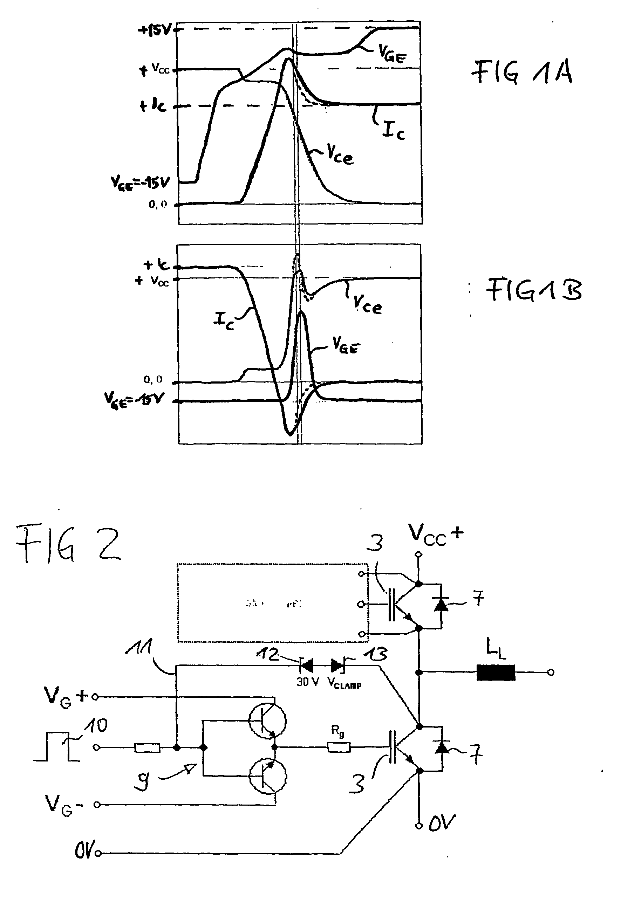

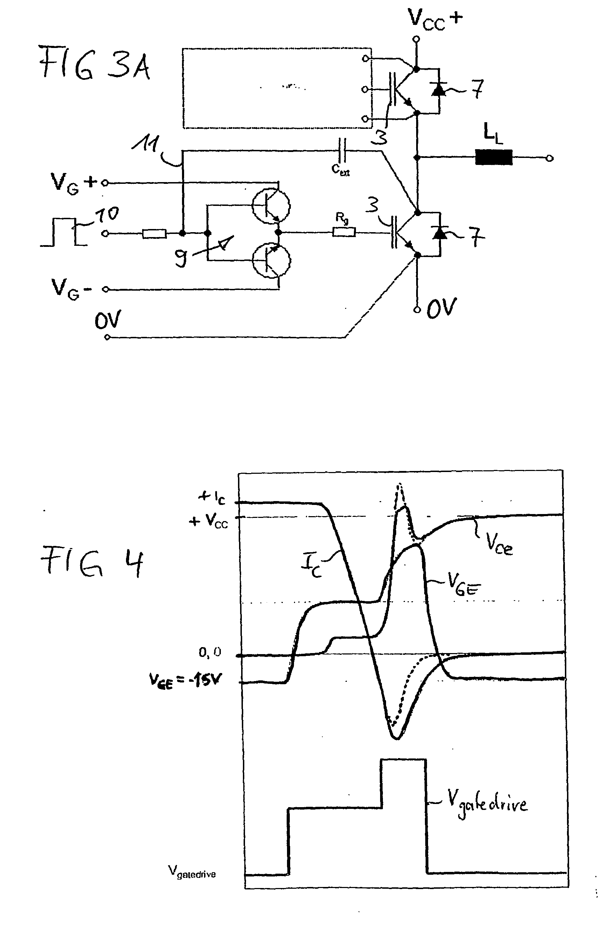

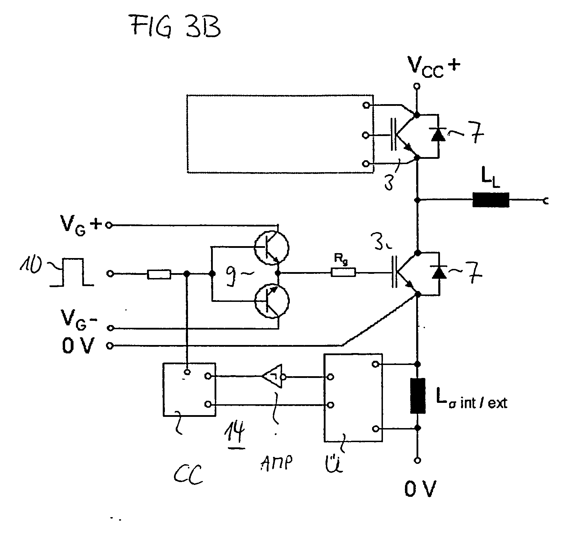

Als Lasttreiber 3 werden hier zwei IGBT-Leistungstransistoren verwendet (vgl. Figur 2, dort ist eine komplette Halbbrücke 6 dargestellt). Vor dem Steueranschluss (Gate) eines jeden IGBT ist ein Gate-Vorwiderstand Rg und davor eine Endverstärkerstufe eines Gate-Treibers GD (vgl. Figur 6) angeordnet. Eine mögliche Ausführung einer solchen Endverstärkerstufe ist die in 9 gezeigte Emitterfolgerschaltung (Figur 2, Figur 3, Schaltungsteil 9). Der Gate-Treiber GD seinerseits ist - wie in Figur 6 dargestellt - mit einem Mikrocontroller 5 verbunden. Die Endverstärkerstufe 9 des Gate-Treibers GD wird mit einer positiven Versorgungsspannung V_{G}+ und einer negativen Versorgungsspannung V_{G}- versorgt und über einen gemeinsamen Steueranschluss mit einem Steuersignal V_{garearive} (vgl. auch Figur 4) beaufschlagt. Dieses Steuersignal V_{gatedrive} wird letztendlich auf das Gate des IGBT durchgeschaltet.

Die Halbbrücke 6 ist üblicherweise als ein integriertes Bauelement ausgebildet. Durch bauteilinterne Streuinduktivitäten L_{σ,int} und durch den Schaltungsaufbau bedingte externe Streuinduktivitäten L_{σ,ext} können während des Abklingens einer beim Schalten verursachten Rückstromspitze Überspannungen (Spannung größer als die Versorgungsspannung V_{cc} der Halbbrücke 6) an der Freilaufdiode 7 induziert werden, die u.U. die für die verwendeten Bauelemente maximal zulässige Spannung übersteigt. Diese Überspannung (oder eine Stromspitze mit einer großen Stromsteilheit di/dt oder einem steilen Spannungsanstieg du/dt), die beim Schalten der Lasttreiber 3 infolge von im Stromkreis befindlichen Induktivitäten induziert werden, gilt es nun zu reduzieren.

Erfindungsgemäß wird der parallel zu der Freilaufdiode 7 liegende Lasttreiber 3 (IGBT) als Begrenzer für die Überspannung an der Freilaufdiode 7 während des Umschaltens ausgenutzt. Die Begrenzung der Überspannung durch den parallel liegenden Lasttreiber 3 wird dadurch erreicht, dass dieser Lasttreiber 3 gezielt während des Abklingens einer Rückstromspitze kurzzeitig, gerade so weit eingeschaltet wird, dass ein additiver, abfallender Strom im Lasttreiber-Freilaufdioden-Paar entsteht. Der additive, abfallende Strom wirkt der induzierten Stromspitze entgegen und reduziert somit die Stromsteilheit in den Streuinduktivitäten L_{σ,int} und L_{σ,ext}. Somit fällt auch die induzierte Überspannung geringer aus.

Das Gate und der Emitter des IGBT werden im ausgeschalteten Zustand des IGBT hochohmig miteinander verbunden. Dies bewirkt das gewünschte kurzzeitige Einschalten des IGBT, wenn die parallel liegende Freilaufdiode 7 abkommutiert wird, weil das Abreißen des Freilaufdiodenstroms neben der hohen Stromsteilheit di/dt auch ein steiler Spannungsanstieg du/dt an der Freilaufdiode 7 und dem parallelem IGBT bewirkt.

Der Spannungsanstieg du/dt führt über die so genannte Millerkapazität im IGBT zu einem Anstieg der Gate-Spannung V_{GE}, die aufgrund der hochohmigen Gate-Emitter-Verbindung nur langsam abgebaut wird. Hierdurch wird der IGBT für die Dauer des Spannungsanstiegs du/dt teilweise eingeschaltet. Dies verringert wiederum den Spannungsanstieg du/dt, der IGBT schaltet wieder ab und wird insgesamt nur geringfügig mit Strom belastet (vgl. dazugehörige Strom-/Spannungsverläufe in den Figuren 1A und 1B).

Die Ergebnisse der Beeinflussung von Überspannungen und Rückstromspitze durch kurzzeitiges Einschalten des zur Freilaufdiode 7" parallel liegenden IGBT (Lasttreiber 3") ist durch die Strom-/Spannungsverläufe in den Figuren 1A und 1B dargestellt. Dabei sind die Strom-/Spannungsverläufe an einem einschaltenden IGBT (Lasttreiber 3') in Figur 1A und die Strom-/Spannungsverläufe an einer, dem anderen, sperrenden IGBT (Lasttreiber 3") parallel geschalteten Freilaufdiode 7" in Figur 1B dargestellt.

Wird die Gate-Spannung V_{GE} des nicht geschalteten (des gewissermaßen gesperrten) IGBT kurzzeitig eingeschaltet, so erhöht sich die Gate-Spannung V_{GE} innerhalb einer kurzen Zeitdauer impulsförmig. Dies führt zu einer deutlichen Reduzierung der Spannungsüberhöhung der Zwischenkreisspannung oder Versorgungsspannung V_{CC} im Vergleich zum Stand der Technik (Strom-/Spannungsverhältnisse des Standes der Technik sind gepunktet dargestellt; vgl. Figuren 8A und 8B). Überdies wird die Stromsteilheit di/dt des geschalteten Laststroms I_{C} kleiner, was jedoch zu mehr Schaltverlusten führt.

Wie aus dem Vergleich der gepunkteten und der durchgezogenen Stromkurven des Laststromes I_{C} in den Figuren 1A und 1B deutlich wird, werden die Schaltverluste hierdurch jedoch nur marginal erhöht. Die Verluste in dem kurzzeitig eingeschalteten IGBT sind aufgrund des geringen geschalteten Stromes zu vernachlässigen.

Um die Stromsteilheit oder die Überspannung deutlicher zu reduzieren, kann für jedes Paar IGBT-Freilaufdiode 3, 7 ein Rückkoppelzweig 11 (Figur 2) vorgesehen sein, der die Spannung an der Kathode der Freilaufdiode 7" (oder am Kollektor des IGBT) auf den Steuereingang des IGBT zurückkoppelt (das Steuersignal V_{gatedrive}, das an der Endverstärkerstufe 9 des Gate-Treibers GD ansteht, wird beeinflusst), wodurch ein kurzzeitiges Einschalten des an sich gesperrten IGBT bewirkt wird.

In dem Rückkoppelzweig 11 können vorteilhaft Zenerdioden (im Ausführungsbeispiel nach Figur 2 eine 30V-Zenerdiode 12, die antiparallel zu einer Clamp-Zenerdiode 13 in Serie geschaltet ist) angeordnet sein. Diese bewirken, dass erst bei Erreichen einer definierten Überspannung an der Freilaufdiode 7" ein Einschalten des dazu parallel liegenden, an für sich gesperrten IGBTs ausgelöst wird (ein so genanntes Überspannungscamping).

Mit Hilfe der Zenerdioden 12, 13 kann bei Erreichen einer Überspannung größer als die Clamp-Spannung durch Rückkopplung in die Endverstärkerstufe 9 des Gate-Treibers GD und damit einem Beeinflussen des Steuersignals V_{gatedrive} ein kurzzeitiges zumindest teilweise Einschalten des IGBTs bewirkt werden.

Im Gegensatz zu einer unmittelbaren Rückkopplung auf den Gate-Anschluss des IGBTs werden die Zenerdioden bei dieser Beschaltung mit wesentlich geringeren Strömen belastet. Auf diese Weise kann ein ähnliches Schaltverhalten erwirkt werden, wie es bereits durch die Strom-/Spannungsverläufe in den Figuren 1A und 1B dargestellt ist.

Statt der beiden Zenerdioden 12, 13 kann im Rückkoppelzweig 11 auch ein externer Kondensators Cₑₓₜ verwendet werden, wie es in Figur 3A dargestellt ist. Dabei wird der Anstieg der Kathodenspannung der Freilaufdiode 7" auf den Steueranschluss des parallel zu der Freilaufdiode 7" geschalteten IGBT zurückgekoppelt, wodurch der IGBT kurzzeitig und zumindest teilweise eingeschaltet wird, was der Spannungsüberhöhung und der Rückstromspitze entgegenwirkt.

Auch die Kombination der beiden letztgenannten Maßnahmen kann vorteilhaft eingesetzt werden: So kann mit Hilfe eines externen Kondensators Cₑₓₜ im Rückkoppelzweig 11 der Steueranschluss des Leistungstreibers während des Spannungsanstieges an der Freilaufeinrichtung auf eine Spannung unterhalb der Einschaltspannung vorgespannt werden. In diesem Fall erfolgt die parallel geschaltete Rückkopplung bei Überschreiten einer Schwellspannung (z.B. über die beschriebene Zenerdiodenschaltung) wesentlich trägheitsfreier, da bis zum Einschaltvorgang des Lasttreibers ein geringerer Spannungshub zu überwinden ist.

In ähnlicher Weise kann auch ein Steuersignal proportional zum Betrag des Stromgradienten in der Freilaufeinrichtung auf den Steueranschluss des Lasttreibers über einen Rückkopplungszweig 14 (beispielsweise mittels eines Übertragers Ü, eines Verstärkers AMP sowie einer Auswerteschaltung CC) rückgekoppelt werden (Figur 3B). Der Stromgradient beim Abfall des Stromes in der Freilaufeinrichtung nach Überschreiten des Maximums der Rückstromspitze wird auf den Steueranschluss des Lasttreibers rückgekoppelt, so dass dieser kurzzeitig zumindest teilweise aufsteuert und den Stromabfall in der Rückstromspitze begrenzt. Diese Maßnahme kann mit der oben oder einer der unten beschriebenen Maßnahmen zur Vorspannung des Steueranschlusses des Lasttreibers kombiniert werden. Auf diese Weise kann mit einfachen Mitteln die Überspannung an der Freilaufeinrichtung reduziert werden.

Bei geeigneter Dimensionierung kann der Stromgradient in der Freilaufeinrichtung vor Erreichen des Maximums der Rückstromspitze genutzt werden, um den Steueranschluss des Lasttreibers auf eine Spannung unterhalb der Einschaltschwelle vorzuspannen. Dieses Verfahren bietet den Vorteil, dass die Anhebung der Steuerspannung am Lasttreiber automatisch synchron zum Kommutierungsvorgang erfolgt.

Die Erfassung des Stromgradienten kann im einfachsten Fall als Spannungsabfall über den Streuinduktivitäten L_{σint}, L_{σext} erfolgen. Gleichsam ist eine transformatorische Erfassung oder die Erfassung und Auswertung des Stromes mit geeigneten Sensoren möglich. Das Vorzeichenwechsel des Stromgradienten macht hierbei gegebenenfalls eine Gleichrichtung oder Auswertung des Signals in einer Fallunterscheidung dI/dt >< 0 notwendig.

Hierdurch kann die Steilheit des Spannungsanstieges an der Freilaufdiode 7" gezielt gesteuert und der Verlauf der Rückstromspitze und folglich auch die Überspannung eingestellt werden. Die Größe des eingestellten Spannungsanstiegs du/dt wird durch die systematische Wahl der Kapazität des Kondensators Cₑₓₜ eingestellt und hängt nicht - wie bei beim ersten Ausführungsbeispiel - von dem sich während des Schaltvorganges veränderten Wert der Millerkapazität ab. Auf diese Weise kann ein ähnliches Schaltverhalten bewirkt werden, wie es bereits durch die Strom-/Spannungsverläufe in den Figuren 1A und 1B dargestellt ist.

Anstatt des Rückkoppelzweiges 11 oder auch zusätzlich zu dem Rückkoppelzweig 11 zwischen (Kathode der) Freilaufdiode 7 und Steueranschluss des IGBT kann auch eine gezielte, zum Zeitpunkt des Schaltvorgangs vorgenommene Ansteuerung des IGBT über das Steuersignal V_{gatedrive} vorgenommen werden. Dabei wird der parallel zur Freilaufdiode 7" liegende IGBT gezielt durch ein vom Zeitpunkt der Rückstromspitze an der Freilaufdiode 7" abhängiges Steuersignal V_{gatedrive} (Figur 4) innerhalb eines bestimmten Zeitfenster während der Kommutierungsphase aufgesteuert (zumindest teilweise eingeschaltet) und anschließend wieder abgeschaltet (gesperrt), und dies zu einem Zeitpunkt, zu dem das eigentlich laststeuernde Steuersignal V_{gatedrive} für diesen IGBT nicht vorgesehen ist.

Das zeitlich auf die Rückstromspitze abgestimmte Steuersignals V_{gatedrive} hebt die Gate-Spannung V_{GE} am zur Freilaufdiode 7" parallel geschalteten und an für sich gesperrten IGBT während des Kommutierungsvorganges gezielt kurzzeitig an. Dadurch steuert der IGBT zumindest teilweise durch.

Die Strom-/Spannungsverhältnisse bei einer solchen Ansteuerung sind exemplarisch im oberen Teil der Figur 4 im Vergleich zum in der Figur 4 gepunktet dargestellten Verlauf aus Figuren 8A und 8B wiedergegeben. Der Laststrom I_{C} sinkt beim Sperren des IGBT und weist im negativen Bereich eine Spitze oder Überhöhung mit einer kleineren Stromsteilheit di/dt im Vergleich zum Stromverlauf auf, wie er sich aus dem Stand der Technik (gepunktet dargestellter Stromverlauf des Laststroms I_{C}) ergibt. Die Zwischenkreisspannung V_{CC} zeigt einen wesentlich kleineren Überschwinger oder geringere Überspannung (kleinere Spitze) auf, da das Aufsteuern des IGBT der Überspannung gezielt entgegenwirkt.

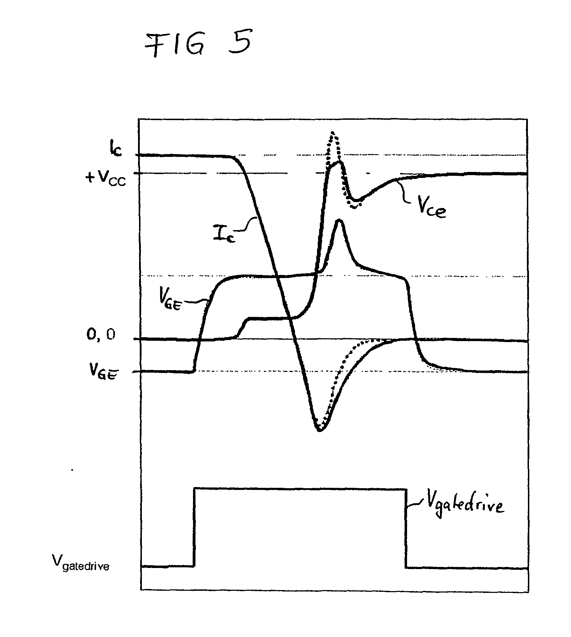

Statt eines stufenförmigen Steuersignals V_{gatedrive} und einer damit verbundenen kurzzeitigen, zusätzlichen Erhöhung der Gate-Spannung V_{GE} kann auch ein rechteckförmiges Steuersignal V_{gatedrive} und eine damit verbundene, im Mittel höhere Gate-Spannung V_{GE} (Figur 5) im Vergleich zu der Gate-Spannung V_{GE} aus Figur 4 vorgesehen sein. Die Gate-Spannung V_{GE} am parallel zur Freilaufdiode 7" liegenden, eigentlich sperrenden IGBT wird während der Kommutierung des Stromes von der Freilaufdiode 7 in einem vorbestimmten, kurzen Zeitfenster während einer Rückstromspitze des Laststroms I_{C} an der Freilaufdiode 7 auftritt, auf einen Wert kleiner als eine Schwellspannung angehoben.

Ähnlich wie beim ersten Ausführungsbeispiel kann hier auch ohne hochohmige Gate-Emitter-Verbindung ein Einschalten als Folge des Spannungsanstiegs du/dt an der Freilaufdiode 7 und der Rückwirkungskapazität (Kondensator Cₑₓₜ) erfolgen.

Vorteil dieses Verfahrens ist es, dass das Spannungsintervall bis zum Einschalten des IGBT reduziert wird und somit die Verzögerungszeit bis zum Einwirken der Rückkopplung des Spannungsanstiegs du/dt minimiert werden kann.

Das zeitlich auf die Rückstromspitze abgestimmte Steuersignal V_{gatedrive} hebt die Spannung am IGBT parallel zur Freilaufdiode 7" in einem bestimmten Zeitfenster an. Hierdurch wird z.B. ein zumindest teilweises Aufsteuern des IGBT durch die Rückwirkungskapazität ermöglicht. Das resultierende Schaltverhalten (Strom-/Spannungsverlauf) ist im oberen Teil der Figur 5 im Vergleich zum Verhalten aus den Figuren 8A und 8B dargestellt.

Die Gate-Spannung V_{GE} wird durch die konstant große Ansteuerung weniger stark erhöht als beim vorherigen Ausführungsbeispiel. Die Kollektorspannung V_{ce}/Spannung an der Freilaufrichtung verhält sich jedoch ähnlich wie beim vorherigen Ausführungsbeispiel, während der Laststrom I_{C} in seiner Stromsteilheit di/dt etwas weniger reduziert wird, aber die Rückstromspitze immer noch deutlich weniger steil ist als die vergleichbare Rückstromspitze bei dem Stand der Technik (vgl. gepunktete Linie für den Laststrom I_{C} in Figur 5).

Um die Spannung an der Freilaufdiode 7 während Umschaltvorgängen zu begrenzen, können auch Schaltungsanordnungen mit Rückkoppelzweig 11 mit zusätzlicher, gezielter Steuerung der Gate-Spannung V_{GE} des IGBT kombiniert werden. Ebenso kann die hochohmige Verbindung des Gates und des Emitters des IGBT im Auszustand - wie es im ersten Ausführungsbeispiel erläutert ist - mit einem Rückkoppelzweig 11 oder einer gezielten, kurzzeitigen Ansteuerung der Gate-Spannung V_{GE} kombiniert werden. Somit ist eine einfache und effektive Reduzierung der Überspannung und/oder der Rückstromspitze an der Freilaufdiode 7 gegeben. Die Freilaufdioden 7 sind somit weitgehend vor Zerstörung geschützt.

Freilaufdioden zum Begrenzen einer induktiven Überspannung sind hinreichend bekannt. Ebenso sind funktionell äquivalente Freilaufeinrichtungen bekannt, die nicht unbedingt mit nur einer einzigen, einem Leistungsschalter parallel geschalteten Diode wirksam sind. Für die Erfindung ist es unwesentlich, ob als Freilaufeinrichtung eine Freilaufdiode oder ein äquivalentes Mittel verwendet wird. Wesentlich hingegen ist, dass eine induktive Überspannung und eine große Stromsteilheit reduziert werden gemäß des erfindungsgemäßen Verfahrens oder mit der erfindungsgemäßen Schaltungsanordnung.

## Patentansprüche

1. Verfahren zum Begrenzen einer Überspannung an einer Freilaufeinrichtung (7), die parallel zu einem Halbleiterleistungsschalter (3) angeordnet ist, wobei zwei Paare aus jeweils parallel geschaltetem Halbleiterleistungsschalter (3) und Freilaufeinrichtung (7) in Reihe geschaltet sind, ein zwischen den beiden Paaren angeordneter Ausgangsanschluss mit einer induktiven Last (L) verbunden ist und einer der Halbleiterleistungsschalter (3") in den gesperrten Zustand und der andere (3') in den nicht gesperrten Zustand gesteuert wird, **dadurch gekennzeichnet, dass** der gesperrte Halbleiterleistungsschalter (3") zum Zeitpunkt des Auftretens einer aufgrund einer Rückstromspitze in der Freilaufeinrichtung (7") von mindestens einer Streuinduktivität induzierten Überspannung an der zugehörigen Freilaufeinrichtung (7") kurzzeitig gerade so weit eingeschaltet wird, dass ein die Rückstromspitze reduzierender Strom in dem Paar aus Halbleiterleistungsschalter (3) und Freilaufeinrichtung (7) erzeugt wird.

2. Verfahren nach Anspruch 1, **dadurch gekennzeichnet, dass** als Halbleiterleistungsschalter (3) ein IGBT oder MOS Leistungstransistor verwendet wird, bei dem der Gate-Anschluss und der Emitter-Anschluss beim an für sich gesperrten IGBT oder MOS Leistungstransistor hochohmig miteinander verbunden werden, wodurch bei Auftreten einer Stromspitze ein kurzzeitiges Einschalten des Haltleiterleistungsschalters (3) erreicht wird.

3. Verfahren nach einem der Ansprüche 1 oder 2, **dadurch gekennzeichnet, dass** der Steueranschluss des gesperrten Halbleiterleistungsschalters (3") mit einem Spannungsimpuls vorbestimmter Dauer und Amplitude zeitlich abgestimmt auf das Auftreten einer Stromspitze an der Freilaufeinrichtung (7") beaufschlagt wird.

4. Verfahren nach einem der vorhergehenden Ansprüche, **dadurch gekennzeichnet, dass** der Steueranschluss des gesperrten Halbleiterleistungsschalters (3") zeitlich abgestimmt auf das Auftreten einer Stromspitze mit einem stufenförmigen Spannungsimpuls vorbestimmter kurzer Zeitdauer beaufschlagt wird.

5. Verfahren nach einem der vorhergehenden Ansprüche, **dadurch gekennzeichnet, dass** die Spannung an der Freilaufeinrichtung (7) über einen Rückkoppelzweig (11) auf den Steueranschluss des gesperrten Halbleiterleistungsschalters (3) zurückgekoppelt wird, wodurch der gesperrte Halbleiterleistungsschalter (3) während der Spannungsspitze kurzzeitig zumindest teilweise eingeschaltet wird.

6. Verfahren nach einem der vorhergehenden Ansprüche, **dadurch gekennzeichnet, dass** die Stromsteilheit (Stromgradient) in der Freilaufeinrichtung (7) über einen weiteren Rückkoppelzweig (14) auf den Steueranschluss des gesperrten Halbleiterleistungsschalters (3) zurückgekoppelt wird derart, dass der gesperrte Halbleiterschalter während der Stromspitze kurzzeitig und zumindest teilweise eingeschaltet wird.

7. Schaltungsanordnung zum Begrenzen einer Überspannung an einer Freilaufeinrichtung (7), die parallel zu einem Halbleiterleistungsschalter (3) angeordnet ist, wobei zwei Paare aus jeweils Halbleiterleistungsschalter (3) und Freilaufeinrichtung (7) in Reihe geschaltet sind, ein zwischen den Paaren angeordneter Ausgangsanschluss mit einer induktiven Last (L_{L}) verbunden ist und einer der Halbleiterleistungsschalter (3") in den gesperrten Zustand und der andere (3') in den nicht gesperrten Zustand gesteuert wird, **dadurch gekennzeichnet, dass** zwischen dem Ausgang eines jeden Halbleiterleistungsschalters (3) und seinem Steueranschluss (9) ein Rückkoppelzweig (11) vorgesehen ist, der den gesperrten Halleiterleistungsschalter (3") zum Zeitpunkt des Auftretens einer aufgrund einer Rückstromspitze in der Freilaufeinrichtung (7") von mindestens einer Streuinduktivität induzierten Überspannung an der zugehörigen Freilaufeinrichtung (7") kurzzeitig gerade so weit einschaltet, dass ein die Rückstromspitze reduzierender Strom in dem Paar aus Halbleiterleistungsschalter (3) und Freilaufeinrichtung (7) erzeugt wird.

8. Schaltungsanordnung nach Anspruch 7, **dadurch gekennzeichnet, dass** der Rückkoppelzweig (11) zumindest ein Bauelement (12, 13) aufweist, das eine Ansteuerung des Steueranschlusses erst über einer Schwellspannung zulässt, so dass nur Spannungen größer als ein vorgegebener Schwellwert auf den Steueranschluss zurückgekoppelt werden.

9. Schaltungsanordnung nach Anspruch 7, **dadurch gekennzeichnet, dass** der Rückkoppelzweig ein Bauelement aufweist (Cₑₓₜ), über das eine Rückkopplung auf den Steueranschluss proportional zum Spannungsanstieg an der Freilaufeinrichtung erfolgt.

10. Schaltungsanordnung nach Anspruch 8, **dadurch gekennzeichnet, dass** als Bauelemente zwei antiparallel geschaltete Zenerdioden (12, 13) im Rückkoppelzweig (11) verwendet werden.

11. Schaltungsanordnung nach Anspruch 9, **dadurch gekennzeichnet, dass** als Bauelement ein Kondensator (Cₑₓₜ) im Rückkoppelzweig (11) verwendet wird.

12. Schaltungsanordnung nach Anspruch 8 oder 9, **dadurch gekennzeichnet, dass** eine Parallelschaltung aus Zenerdioden und externem Kondensator im Rückkoppelzweig verwendet wird.

13. Schaltungsanordnung nach einem der Ansprüche 7 bis 12, **dadurch gekennzeichnet, dass** der Rückkoppelzweig so ausgebildet ist, dass er eine Aufsteuerung des Steueranschlusses erst über einem Schwellwert der Stromsteilheit (des Stromgradienten) durch die Freilaufeinrichtung zulässt.

14. Schaltungsanordnung nach Anspruch 13, **dadurch gekennzeichnet, dass** für die Rückkopplung der Spannungsabfall an internen und/oder externen Streuinduktivitäten genutzt wird.

15. Schaltungsanordnung nach Anspruch 13, **dadurch gekennzeichnet, dass** der Stromanstieg durch die Induktion in einem Transformator rückgekoppelt wird.

16. Schaltungsanordnung nach einem der Ansprüche 7 bis 15, **dadurch gekennzeichnet, dass** als Halbleiterleistungsschalter (3) ein IGBT-Leistungstransistor verwendet wird.

## Claims

1. Method for limiting an overvoltage at a freewheeling device (7) arranged in parallel with a semiconductor power switch (3), two pairs respectively composed of parallel-connected semiconductor power switches (3) and a freewheeling device (7) being connected in series, an output terminal arranged between the two pairs being connected to an inductive load (L_{L}), and one of the semiconductor power switches (3") being controlled into the turned-off state and the other (3') being controlled into the non-turned-off state, **characterized in that** the turned-off semiconductor power switch (3"), at the instant of the occurrence of an overvoltage at the associated freewheeling device (7"), said overvoltage being induced by at least one leakage inductance on account of a reverse current spike in the freewheeling device (7"), is switched on momentarily, precisely to an extent such that a current that reduces the reverse current spike is generated in the pair composed of semiconductor power switch (3) and freewheeling device (7).

2. Method according to Claim 1, **characterized in that** the semiconductor power switch (3) used is an IGBT or MOS power transistor, in the case of which the gate terminal and the emitter terminal are connected to one another with high impedance in the case of the intrinsically turned-off IGBT or MOS power transistor, as a result of which a momentary switch-on of the semiconductor power switch (3) is achieved when a current spike occurs.

3. Method according to either of Claims 1 and 2, **characterized in that** the control terminal of the turned-off semiconductor power switch (3") has applied to it a voltage pulse of predetermined duration and amplitude in a manner temporally coordinated with the occurrence of a current spike at the freewheeling device (7").

4. Method according to one of the preceding claims, **characterized in that** the control terminal of the turned-off semiconductor power switch (3") has applied to it a stepped voltage pulse of predetermined short time duration in a manner temporally coordinated with the occurrence of a current spike.

5. Method according to one of the preceding claims, **characterized in that** the voltage at the freewheeling device (7) is fed back via a feedback path (11) to the control terminal of the turned-off semiconductor power switch (3), as a result of which the turned-off semiconductor power switch (3) is momentarily at least partially switched on during the voltage spike.

6. Method according to one of the preceding claims, **characterized in that** the current gradient in the freewheeling device (7) is fed back via a further feedback path (14) to the control terminal of the turned-off semiconductor power switch (3) in such a way that the turned-off semiconductor switch is momentarily and at least partially switched on during the current spike.

7. Circuit arrangement for limiting an overvoltage at a freewheeling device (7) arranged in parallel with a semiconductor power switch (3), two pairs respectively composed of semiconductor power switch (3) and a freewheeling device (7) being connected in series, an output terminal arranged between the pairs being connected to an inductive load (L_{L}), and one of the semiconductor power switches (3") being controlled into the turned-off state and the other (3') being controlled into the non-turned-off state, **characterized in that** a feedback path (11) is provided between the output of each semiconductor power switch (3) and its control terminal (9), by which feedback path the turned-off semiconductor power switch (3"), at the instant of the occurrence of an overvoltage at the associated freewheeling device (7"), said overvoltage being induced by at least one leakage inductance on account of a reverse current spike in the freewheeling device (7"), is switched on momentarily, precisely to an extent such that a current that reduces the reverse current spike is generated in the pair composed of semiconductor power switch (3) and freewheeling device (7).

8. Circuit arrangement according to Claim 7, **characterized in that** the feedback path (11) has at least one component (12, 13), which permits a driving of the control terminal only above a threshold voltage, so that only voltages greater than a predetermined threshold value are fed back to the control terminal.

9. Circuit arrangement according to Claim 7, **characterized in that** the feedback path has a component (Cₑₓₜ), via which a feedback to the control terminal is effected in a manner proportional to the voltage rise at the freewheeling device.

10. Circuit arrangement according to Claim 8, **characterized in that** two zener diodes (12, 13) connected in antiparallel are used as the components in the feedback path (11).

11. Circuit arrangement according to Claim 9, **characterized in that** a capacitor (Cₑₓₜ) is used as the component in the feedback path (11).

12. Circuit arrangement according to Claim 8 or 9, **characterized in that** a parallel circuit comprising zener diodes and an external capacitor is used in the feedback path.

13. Circuit arrangement according to one of Claims 7 to 12, **characterized in that** the feedback path is designed such that it permits the control terminal to be driven up only above a threshold value of the current gradient through the freewheeling device.

14. Circuit arrangement according to Claim 13, **characterized in that** the voltage drop across internal and/or external leakage inductances is utilized for the feedback.

15. Circuit arrangement according to Claim 13, **characterized in that** the current rise is fed back through the induction in a transformer.

16. Circuit arrangement according to one of Claims 7 to 15, **characterized in that** an IGBT power transistor is used as the semiconductor power switch (3).

## Revendications

1. Procédé de limitation d'une surtension sur un dispositif (7) à roue libre qui est monté parallèlement à un commutateur (3) de puissance à semiconducteur, deux paires respectivement de commutateur (3) de puissance à semiconducteur et de dispositif (7) à roue libre montés en parallèle étant montées en série, une borne de sortie disposée entre les deux paires étant reliée à une charge (L) inductive et l'un des commutateurs (3") de puissance à semiconducteur étant mis à l'état bloqué et l'autre (3"') à l'état non bloqué, **caractérisé en ce que** le commutateur (3") de puissance à semiconducteur bloqué est, à l'instant de l'apparition, d'une surtension sur le dispositif (7") à roue libre associé induite par au moins une inductance de dispersion en raison d'une pointe de courant en retour dans le dispositif (7") à roue libre, mis à l'état passant pendant une courte durée précisément jusqu'à ce qu'un courant réduisant la pointe de courant en retour soit produit dans la paire composée du commutateur (3) de puissance à semiconducteur et du dispositif (7) à roue libre.

2. Procédé suivant la revendication 1, **caractérisé en ce qu'**on utilise comme commutateur (3) de puissance à semiconducteur, un transistor de puissance IGBT ou MOS, dans lequel la borne de grille et la borne d'émetteur sont reliées l'une à l'autre a grande valeur ohmique pour le transistor de puissance IGBT ou MOS bloqué en soi de sorte que, lorsqu'il apparaît une pointe de courant, on atteint un nouvel état passant de courte durée du commutateur (3) de puissance à semiconducteur.

3. Procédé suivant l'une des revendications 1 ou 2, **caractérisé en ce que** la borne de commande du commutateur (3") de puissance à semiconducteur bloqué est alimentée par une impulsion de tension de durée et d'amplitude déterminée à l'avance, adaptée dans le temps à l'apparition d'une pointe de courant sur le dispositif (7") à roue libre.

4. Procédé suivant l'une des revendications précédentes, **caractérisé en ce que** la borne de commande du commutateur (3") de puissance à semiconducteur bloqué est alimentée d'une manière adaptée dans le temps à l'apparition d'une pointe de courant ayant une impulsion de tension en forme de paliers d'une durée courte déterminée à l'avance.

5. Procédé suivant l'une des revendications précédentes, **caractérisé en ce que** la tension aux bornes du dispositif (7) à roue libre est couplée en retour par une branche (11) de réaction à la borne de commande du commutateur (3) de puissance à semiconducteur bloqué de sorte que le commutateur (3) de puissance à semiconducteur bloqué est mis à l'état passant au moins partiellement pendant une courte durée pendant la pointe de tension.

6. Procédé suivant l'une des revendications précédentes, **caractérisé en ce que** la pente de courant (gradient de courant) dans le dispositif (7) à roue libre est couplée en retour par une autre branche (14) de réaction à la borne de commande du commutateur (3) de puissance à semiconducteur bloqué de manière à ce que le commutateur à semiconducteur bloqué soit mis à l'état passant, pendant une courte durée et au moins en partie, pendant la pointe de courant.

7. Montage de limitation d'une surtension sur un dispositif (7) à roue libre qui est monté en parallèle à un commutateur (3) de puissance à semiconducteur, deux paires composées respectivement d'un commutateur (3) de puissance à semiconducteur et d'un dispositif (7) à roue libre étant montées en série, une borne de sortie disposée entre les paires étant reliée à une charge (L_{L}) inductive et l'un des commutateurs (3") de puissance à semiconducteur étant mis à l'état bloqué, tandis que l'autre (3') est à l'état non bloqué, **caractérisé en ce qu'**il est prévu, entre la sortie de chaque commutateur (3) de puissance à semiconducteur et sa borne (9) de commande, une branche (11) de réaction qui met pendant une durée courte le commutateur (3") de puissance à semiconducteur bloqué, à l'instant de l'apparition d'une surtension sur le dispositif (2") à roue libre associé induite par au moins une inductance de dispersion en raison d'une pointe de courant de retour dans le dispositif (7") à roue libre, précisément à l'état passant tant qu'un courant réduisant la pointe de courant de retour est produit dans la paire composée du commutateur (3) de puissance à semiconducteur et du dispositif (7) à roue libre.

8. Montage suivant la revendication 7, **caractérisé en ce que** la branche (11) de réaction a au moins un composant (12, 13) qui autorise une commande de la borne de commande seulement au-dessus d'une tension de seuil de sorte que seulement des tensions plus hautes d'une valeur de seuil prescrite sont couplées en retour à la borne de commande.

9. Montage suivant la revendication 7, **caractérisé en ce que** la branche de réaction a un composant (Cₑₓₜ) par lequel une réaction sur la borne de commande s'effectue proportionnellement à l'élévation de tension sur le dispositif à roue libre.

10. Montage suivant la revendication 8, **caractérisé en ce que** deux diodes (12, 13) Zener montées tête bêche sont utilisées comme composants dans la branche (11) de réaction.

11. Montage suivant la revendication 9, **caractérisé en ce qu'**un condensateur (Cₑₓₜ) est utilisé comme composant dans la branche (11) de réaction.

12. Montage suivant la revendication 8 ou 9, **caractérisé en ce qu'**un circuit parallèle composé de diodes Zener et d'un condensateur extérieur est utilisé dans la branche de réaction.

13. Montage suivant l'une des revendications 7 à 12, **caractérisé en ce que** la branche de réaction est telle, qu'elle autorise une commande de la borne de commande seulement au-dessus d'une valeur de seuil de la pente du courant (du gradient de courant) passant dans le dispositif à roue libre.

14. Montage suivant la revendication 13, **caractérisé en ce qu'**il est utilisé, pour la réaction, la chute de tension aux bornes d'inductances de dispersion intérieures et/ou extérieures.

15. Montage suivant la revendication 13, **caractérisé en ce que** l'élévation de courant est couplée en retour par l'induction dans un transformateur.

16. Montage suivant l'une des revendications 7 à 15, **caractérisé en ce qu'**il est utilisé un transistor de puissance IGBT comme commutateur (3) de puissance à semiconducteur.
